# EUROPÄISCHE PATENTSCHRIFT

(11) **EP 2 259 996 B1**
(45) Veröffentlichungstag und Bekanntmachung des Hinweises auf die Patenterteilung: **19.10.2011**
(21) Anmeldenummer: 09717253.0
(22) Anmeldetag: 17.02.2009
(51) Int. Cl.: B81C 3/00

(54) **Mikrohalterung für eine Mikrokanalplatte**
Micro-fixture for a micro-channel plate
Micro-dispositif de fixation pour une plaque à microcanaux

(30) Priorität: 29.02.2008 DE 102008011972
(43) Veröffentlichungstag der Anmeldung: 15.12.2010
(73) Patentinhaber: Bayer Technology Services GmbH, 51368 Leverkusen (DE)
(72) Erfinder: HAUSCHILD, Jan-Peter, 28816 Stuhr (DE); WAPELHORST, Eric, 28329 Bremen (DE); MÜLLER, Jörg, 121244 Buchholz (DE)
(86) Internationale Anmeldenummer: PCT/EP2009/001088
(87) Internationale Veröffentlichungsnummer: WO 2009/109288

(56) Entgegenhaltungen:
- EP-A- 1 700 821
- US-A- 5 903 059
- US-A1- 2007 087 474
- WAPELHORST E ET AL: "A One - Chip Solution of a Mass Spectrometer" SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10. Juni 2007 (2007-06-10), Seiten 2015-2018, XP031216458 ISBN: 978-1-4244-0841-2
- LOMAS D G ET AL: "A high-resolution, two-dimensional, electron imaging integrated circuit" MEASUREMENT SCIENCE AND TECHNOLOGY, IOP, BRISTOL, GB, Bd. 9, Nr. 3, 1. März 1998 (1998-03-01), Seiten 391-398, XP020064439 ISSN: 0957-0233

## Beschreibung

Die vorliegende Erfindung bezieht sich allgemein auf das Gebiet der mikro-elektromechanischen Systeme (MEMS). Gegenstand der vorliegenden Erfindung ist eine Vorrichtung nach Anspruch 2 sowie die Verwendung einer entsprchen den Vorrichtung nach Anspruch 1.

Die Mikrosystemtechnik kombiniert Methoden der Mikroelektronik, der Mikromechanik, der Mikrofluidik und der Mikrooptik, aber auch Entwicklungen der Informatik, Biotechnologie und Nanotechnologie, indem sie Entwicklungen und Strukturen aus diesen Bereichen zu neuen Systemen vereinigt. Die Abmessungen der funktionsbestimmenden Strukturen liegen im Mikrometerbereich, was als Abgrenzung zur Nanotechnologie herangezogen werden kann.

Während sich die Mikroelektronik auf elektrische Komponenten wie Transistoren (CPU) und Kondensatoren (RAM) beschränkt, beschäftigt sich die Mikrosystemtechnik mit dem Entwurf und der Herstellung von mikroelektronischen Schaltungen und mikromechanischer sowie mikrooptischer Bauelemente und ihrer Integration zu einem System sowohl als diskrete Komponenten, als auch monolithisch z.B. in Halbleitermaterialien wie kristallinem Silizium oder Galliumarsenid.

In Mikrosystemen, im englischen auch *micro electro mechanical systems* (MEMS) genannt, wirken Sensoren, Aktoren und Datenverarbeitung zusammen. Beispiele sind optische Sensoren in kabellosen Mäusen, oder Bubble-Jet-Druckköpfe moderner Drucker, Beschleunigungs- und Drehratensensoren zur Auslösung von Airbags und zur Steuerung von Stabilitäts- und Navigationssystemen, Instrumente der minimal-invasiven Chirurgie, Endoskopsysteme, chemische Sensoren für die Lebensmittelüberwachung, Mikrofestplatten oder Mikrospiegelaktor-Chips in Beamern oder auch organische Leuchtdioden. Ein Randbereich der Mikrosystemtechnik ist die Mikroverfahrenstechnik, die sich mit physikalischen und/oder chemischen Prozessen beschäftigt, die in mikro strukturierten Apparaten ablaufen.

Mikrosysteme basierten früher überwiegend auf der Halbleiterelektronik, das Grundmaterial (Substrat) war in der Regel Silizium oder Galliumarsenid. Heute können Mikrosysteme auch preiswert aus Kunststoffen hergestellt werden und die Ergebnisse im Bereich Materialforschung werden für multifunktionale Systeme genutzt.

Oftmals werden Mikrosysteme nicht monolithisch aus einem Wafer hergestellt sondern bestehen aus verschiedenen Komponenten, die miteinander zu einem hybriden Mikrosystem verbunden werden. Das Mikrosystem verfügt dementsprechend über Verbindungsstellen, welche die Verbindung von mehreren Komponenten zu einem System erlaubt. Ein Beispiel einer solchen Verbindungsstelle sind Halterungen zur Aufnahme und Fixierung einer Komponente des Mikrosystems. Zur Verdeutlichungen wird als Beispiel ein Mikromassenspektrometer betrachtet.

Mikromassenspektrometer sind aus dem Stand der Technik bekannt (siehe z.B. *"*Complex MEMS: A fully integrated TOF micro mass spectrometer" veröffentlicht in Sensors and Actuators A: Physical, 138 (1) (2007), 22-27) Bisher wurde es nicht erreicht, alle Komponenten eines Mikromassenspektrometers monolithisch in einem Werkstück herzustellen. Der Sekundärelektronenvervielfacher ist z.B. ein komplexes Bauteil, das separat gefertigt und mit den übrigen Komponenten eines Mikromassenspektrometers zu einem Gesamtsystem verbunden werden muss. Hierfür ist eine Halterung erforderlich, welche den Sekundärionenvervielfacher aufnimmt und gegenüber anderen Komponenten des Systems fixiert.

Im Fall eines Mikromassenspektrometers liegt die Verwendung einer Mikrokanalplatte (engl. Microchannel plate) als Sekundärionenvervielfacher nahe.

Eine Mikrokanalplatte ist ein flächenhafter, bildauflösender Sekundärelektronenvervielfacher. Sie dient zur rauscharmen Verstärkung geringer Ströme freier Elektronen oder anderer ionisierender Partikel, die mit einer gewissen Energie auf die Eingangsseite der Platte aufschlagen und dort Sekundärelektronen auslösen.

Die Mikrokanalplatte umfasst zwei metallisierte Plattenseiten, zwischen denen eine Beschleunigungsspannung anliegt. Die Platte selbst besteht aus einem Halbleiter und ist ähnlich wie ein Sieb durchlöchert, beziehungsweise durchzogen von mikroskopisch feinen Kanälen, die typischerweise einen Lochabstand von ca. 10 µm und einen Durchmesser von ca. 6-8 µm besitzen. Die Platte hat eine Dicke von wenigen Zehntel Millimetern und die Kanäle sind um ca. 10° gegen die Plattenachse verkippt, so dass die einfallenden Elektronen mit Sicherheit mehrmals die Kanalwand treffen. Sie werden dann von einer zwischen den Platten längs der Kanäle anliegenden elektrischen Spannung beschleunigt und vervielfachen sich bei jedem Wandstoß. Jeder einzelne Kanal verhält sich somit wie ein mikroskopischer Elektronenvervielfacher, wie er beispielsweise im Fotovervielfacher eingesetzt wird.

An der Austrittsseite hat sich die Zahl der Elektronen durch Vielfachstöße mit der Kanalwand um das ca. 1000-fache erhöht. Durch eine Nachbeschleunigungsstrecke werden die verstärkten (=vervielfachten) Elektronen auf den eigentlichen Detektor gelenkt, meist einen Leuchtschirm, aber auch beispielsweise ein ebCCD- das electron bombarded CCD, eine Sonderform des CCD zum Nachweis von freien Elektronen, sowie auf einen Elektronenfänger z.B. ausgeführt als Farady-Detektor.

Mikrokanalplatten werden in verschiedenen Messsystemen wie Massenspektrometern, Elektronenvervielfachern und Nachtsichtsystemen zur Verstärkung geringer "primärer" Elektronen- bzw. Ionenströme verwendet. Treten Primärstrahlen (Elektronen, Ionen, Photonen) auf sehr kleinen Querschnitten an genau definierten Orten auf, wie dies insbesondere bei Anwendungen in der Mikrosystemtechnik oder der integrierten und Mikro-Optik zutrifft, so müssen die Kanäle der Mikrokanalplatten dazu mit einer Genauigkeit im Mikrometerbereich justiert werden.

Für solche Anwendungen wäre es von Vorteil, wenn diese hybrid integrierte Mikrokanalplatte in einer Führung eingesetzt werden könnte, die unmittelbar zur Primärstrahlstruktur orientiert ist.

Zusätzlich zur mikrometergenauen Justage zum Ionenkanal wäre es vorteilhaft, wenn die Haltevorrichtung die Mikrokanalplatte gleichzeitig an dieser Stelle fixieren und elektrisch kontaktieren würde. Im Fall des beschriebenen Beispiels ist weiterhin ein Elektronenfänger notwendig und es muss sichergestellt werden, dass elektrische Felder, die aus der Hochspannung an der Platte resultieren, so abgeschirmt werden, dass sie die Funktion des Mikrosystems, z.B. die eines Massenspektrometers, nicht beeinflussen.

Auch bei der Herstellung von mikrooptischen Systemen ist die Ausrichtung von Komponenten von großer Wichtigkeit. Die grundsätzliche Natur des Lichts bedingt, dass lichterzeugende, -übertragende und -verändernde Komponenten präzise zueinander positioniert sein müssen. Montagevorrichtungen und Halterungen in mikrooptischen sind im Allgemeinen auf mechanische Strukturen beschränkt, die vorwiegend der genauen Positionierung der Komponenten dienen. Sie nutzen vorzugsweise in Siliziumsubstrate eingebrachte Strukturen, auf denen unterschiedliche Komponenten (z.B. optische Faser, Laser- und Detektordioden) zueinander justiert integriert werden oder metallische, vorzugsweise kreisförmige Strukturen aus Lot, sog. Bumps, die eine Justage während des Lotaufschmelzvorganges erlauben.

Lötverbinden und Laserschweißen sind zwei übliche Befestigungs- bzw. Montagetechniken in der Mikrosystemtechnik. Im Fall des Laserschweißens kann beispielsweise die zu befestigende Komponente in einer Klemme gehalten werden, welche dann ausgerichtet und mit einem Substrat verschweißt wird. Nachteilig ist u.a., dass die Komponente irreversibel mit einem Substrat verbunden ist; ein Austausch der Komponente ist nicht möglich.

In EP1230571B1 wird eine Vorrichtung zur aktiven Glasfaserausrichtung mit plastisch verformbarer Halteeinrichtung beschrieben, die jedoch keine elektrische Kontaktierung beinhaltet.

In EP1345843B1 wird eine Vorrichtung zur Befestigung von völlig befreiten Mikrobauteilen beschrieben, die jedoch keine selbstjustierende Montage eine Komponente ermöglicht.

In der Offenlegungsschrift US 2007/087474 A1 wird eine selbstjustierende Halterung für einen Chip mit einem mikromechanischen Beschleunigungsnehmer beschrieben. Die Halterung umfasst eine leitende Federstruktur und einen seitlichen Anschlag in einem Kanal, die zur Fixierung des Chips dienen. Die Federstruktur und der Anschlag sind beide im Device Layer eines SO1-Substrats hergestellt, d.h. sie sind auf einer nichtleitenden Oxidschicht angeordnet.

Im Artikel von Lomas et al. "A high-resolution, two-dimensional, electron imaging integrated circuit", MEASUREMENT SCIENCE AND TECHNOLOGY, IOP, BRISTOL, GB, Bd. 9, Nr. 3, 1. März 1998, Seiten 391-398, ISSN: 0957-0233, wird gezeigt, wie eine Mikrokanalplatte zwischen zwei Metallrahmen gehaltert wird. Diese Montageart ist jedoch nicht selbstjustierend.

Es stellt sich damit ausgehend vom beschriebenen Stand der Technik die Aufgabe, eine Halterung für die Integration von Komponenten in MEMS bereitzustellen, die eine selbstjustierende Montage der Komponente ermöglicht. Die gesuchte Halterung soll eine reversible Verbindung zwischen der Komponente und einem Substrat ermöglichen. Neben der mechanischen Fixierung der Komponente soll eine elektrische Kontaktierung erfolgen. Die Halterung soll kostengünstig herzustellen und flexibel und einfach in ihrer Handhabung sein.

Überraschend wurde gefunden, dass diese Aufgabe besonders effektiv durch leitende Federstrukturen gelöst werden kann, die auf einem nicht leitenden Substrat aufgebaut sind.

Gegenstand der vorliegenden Erfindung ist daher eine Vorrichtung zur selbstjustierenden Montage und Halterung gemäss Anspruch 2 und deren Verwendung gemäss Anspruch 1.

Die erfindungsgemäße Vorrichtung, im Folgenden auch Halterung genannt, eignet sich bevorzugt aber nicht ausschließlich zur Integration von Komponenten in einem hybriden Mikrosystem. Unter Mikrosystem wird allgemein eine Anordnung von Strukturen und/oder Komponenten mit Abmessungen im Mikrometerbereich verstanden, wobei die Strukturen und/oder Komponenten als System zusammenwirken. Unter einem hybriden Mikrosystem wird ein Mikrosystem verstanden, das über Komponenten verfügt, die in separaten Herstellungsverfahren gefertigt und zu einem kompletten System zusammengefügt/verbunden wurden.

Die erfindungsgemäße Halterung löst die komplexe Aufgabe der selbstjustierenden Montage, Halterung und elektrischen Kontaktierung einer Mikrokanalplatte in einer einzigen Struktur, die vorzugsweise im gleichen Herstellungsprozess und damit in der gleichen Maskenebene wie ein Teil der Mikrosystemstrukturen erzeugt wird.

Die erfindungsgemäße Halterung weist mindestens eine Federstruktur auf. Unter einer Federstruktur wird ein Vorsprung verstanden, der sich in einer Ruhelage befindet und durch eine äußere Kraft aus dieser Ruhelage ausgelenkt werden kann, wobei der äußeren Kraft eine Federkraft des Vorsprungs entgegenwirkt, die bei Wegfall der äußeren Kraft dafür sorgt, dass der Vorsprung wieder reversibel in die Ruhelage zurückkehrt.

Die Federstruktur sorgt unter anderem dafür, dass die Mikrokanalplatte die zu einem Substrat montiert und gehaltert werden soll, in einer definierten Lage fixiert wird. Durch das Einbringen der Mikrokanalplatte in die erfindungsgemäße Halterung wird die Federstruktur aus ihrer Ruhelage ausgelenkt und übt eine Federkraft auf die Mikrokanalplatte aus, so dass sie Mikrokanalplatte eine definierte Lage gebracht wird. Weiterhin ist die Federstruktur aus einem leitfähigen Material gefertigt oder mit einem leitfähigen Material versehen. Erfindungsgemäß stellt der mechanische Kontakt zwischen der Mikrokanalplatte und der Feder zugleich einen elektrischen Kontakt dar.

Weiterhin verfügt die erfindungsgemäße Halterung über mindestens einen Anschlag, gegen den die Mikrokanalplatte geschoben und/oder gedrückt wird und der eine Begrenzung darstellt. Die Mikrokanalplatte wird bei der Verbindung mit einem Substrat gegen mindestens einen Anschlag geschoben und/oder gedrückt, so dass der Anschlag eine Barriere für die weitere Verschiebung der Mikrokanalplatte darstellt und die Lage der fixierten Mikrokanalplatte zumindest in einer Dimension festlegt.

Erfindungsgemäß sind die mindestens eine Federstruktur und der mindestens eine Anschlag auf einem nicht leitenden Substrat aufgebracht. Unter einem Substrat wird allgemein ein Teil des Mikrosystems verstanden, auf dem Strukturen des Mikrosystems an- oder aufgebracht sind oder mit dem Komponenten des Mikrosystems verbunden werden. Unter einem nicht leitenden Material wird ein Material verstanden, dass eine elektrische Leitfähigkeit von typischerweise weniger als 10⁻⁷ S/m besitzt. Als nichtleitendes Material wird zum Beispiel Kunststoff, Glas, Keramik oder ein Verbundwerkstoff eingesetzt.

In einer bevorzugten Ausführungsform sind auf dem nicht leitenden Substrat Leiternahmen aufgebracht, die eine elektrische Kontaktierung der mindestens einen leitenden Federstruktw erlauben.

In einer bevorzugten Ausfiihrungsform sind die Strukturen, welche die Halterung bilden, zusammen mit zumindest einem Teil der Strukturen des Mikrosystems, z.B. eines Mikromassenspektrometers, hergestellt worden.

Die Herstellung von Strukturen in Mikrosystemen ist dem Fachmann der Mikrosystemtechnik bekannt. Mikrofertigungstechniken sind z.B. in dem Buch "Fundamentals of Microfabrication" von Marc Madou, CRC Press Boca Raton FLA 1997 oder in dem Buch "Mikrosystemtechnik für Ingenieure" von W. Menz. J. Mohr und O. Paul, Wiley-VCH, Weinheim 2005, beschrieben und illustriert.

Maßgeblich beruhen die Technologien der Mikrosystemtechnik auf der Strukturierung von Siliziumsubstraten mit hohem Aspektverhältnis (z.B. schmale Gräben (~µm) mit großer Tiefe ~100µm)) mit Strukturgenauigkeiten im Mikrometerbereich mit nasschemischen, vorzugsweise Plasmaätzprozessen kombiniert mit im thermischen Ausdehnungskoeffizienten angepassten natriumhaltigen Glassubstraten (z.B. Pyrex^{®}), die mit einfachen geätzten Strukturen versehen werden und vorzugsweise mit dem so genannten anodischen Bonden direkt, alternativ mit einer als Lotlegierung (AuSi) fungierenden Au-Dünnschicht hermetisch dicht miteinander verbunden werden.

Metallische Strukturen mit hohem Aspektverhältnis lassen sich durch galvanisches Aufwachsen in dicken Photolacken (> 100µm) mit vergleichbarer Genauigkeit realisieren (UV-LIGA). Unter Einsatz von Dünnschichttechnologien wie Hochvakuumverdampfen und Kathodenzerstäubung (Sputtern), PVD-Prozessen oder der chemischen Abscheidung aus der Gasphase (CVD-Prozesse) vorzugsweise im Plasma in Kombination mit Photolithographie und Ätztechniken lassen sich auf diesen Substraten Funktionsschichten wie Metallisierungen, hydrophobe oder hydrophile Oberflächen und Funktionselemente wie Ventil-Dichtungen und Membranen, Heizelemente, Temperatur-, Druck- und Strömungssensoren in einer vollständig prozesskompatiblen Technologie integrieren. Durch Nutzung von in definierten Bereichen in Abscheide- oder Strukturierungsprozessen sich vorzugsweise selbstorganisierenden Kohlenstoff-Nanoröhrechen aber auch Siliziumnadeln oder Metall-Cluster-Strukturen lassen sich auf diesen Nanostrukturen basierende Funktionen in Mikrosysteme integrieren.

Die Strukturen der erfindungsgemäßen Halterung (Federstruktur, Anschlag) werden vorzugsweise, so wie auch viele Mikrosysteme, in einer Silizium-Glas-Technologie hergestellt. Vorzugsweise werden sie zusammen mit zumindest einem Teil der Strukturen des Mikrosystems, z.B. eines Mikromassenspektrometers oder einer Faserhalterung hergestellt, indem zunächst auf das nicht leitende Substrat Leiterbahnstrukturen für verschiedene Kontaktierungen (z.B. für die leitenden Federstrukturen) aufgebracht werden. Darauf wird vorzugsweise durch eutektisches Bonden ein vorzugsweise einige 100 µm dickes, hochdotiertes Halbleitersubstrat, bevorzugt Silizium, lokal im Bereich der Elektroden aufgebondet, aus dem die Strukturen in einem sich anschließenden Photoätzprozess bis hin zum nicht leitenden Substrat durchstrukturiert werden. Alternativ können diese leitenden Strukturen auch durch einen galvanischen Aufbau von Metall in entsprechend strukturierten Lacken ausreichender Dicke von vorzugsweise einigen 100 µm erzeugt werden. Das Gesamtsystem kann ggf. mit einem weiteren nicht leitenden Substrat abgedeckt werden.

Die erfindungsgemäße Halterung eignet sich besonders zur Integration einer Mikrokanalplatte in einem hybriden Mikrosystem, z.B. zur Herstellung eines Mikromassenspektrometers. Gegenstand der vorliegenden Erfindung ist daher auch die Verwendung der erfindungsgemäßen Halterung zur Aufnahme und Fixierung und elektrischen Kontaktierung einer Mikrokanalplatte.

Gegenstand der vorliegenden Erfindung ist eine Vorrichtung, gemäss Anspruch 2 mindestens umfassend eine entsprechende Halterung und eine Mikrokanalplatte. Eine solche erfindungsgemäße Vorrichtung umfasst neben der Mikrokanalplatte die folgenden Elemente:
- Strukturen aus einem leitenden Material zur Aufnahme einer Mikrokanalplatte, die auf einem nicht leitenden Träger aufgebracht sind,
- federnde Strukturen die die Mikrokanalplatte selbstjustierend positionieren und gleichzeitig eine elektrische Kontaktierung vornehmen,
- mindestens einen Anschlag zur Positionierung der Mikrokanalplatte,

Zusätzlich umfasst die Vorrichtung vorzugsweise
- mindestens eine Schirmelektrode zur Abschirmung übriger Komponenten eines Mikrosystems von der Hochspannung und/oder
- einen Elektronenfänger, der vorzugsweise mit mindestens einer Schirmelektrode geschirmt ist.

In einer bevorzugten Ausführungsform sind alle genannten Elemente durch Photolithographie in der gleichen Maskenebene erzeugt worden. Bevorzugt sind Leiterbahnen auf dem Substrat vorhanden, die eine elektrisch Kontaktierung der Elemente ermöglichen.

Die beschriebene Vorrichtung eignet sich sehr gut zur Verstärkung von Primärstrahlen (Elektronen, Ionen, Photonen) in Mikrosystemen. Sie ist daher z.B. zur Verwendung in Massenspektrometern, E-lektronenvervielfachem, Nachtsichtsystemen, Photovervielfachern, Geigerzählern, Strahlendosimetem und anderen vergleichbaren Messsystemen geeignet.

Gegenstand der vorliegenden Erfindung ist insbesondere die Verwendung der erfindungsgemäßen Vorrichtung in einem Mikromassenspektrometer, Elektronenvervielfacher, Nachtsichtsystem, Photovervielfacher, Teilchenzähler oder Strahlendosimeter. Besonders bevorzugt wird die Vorrichtung in einem Mikromassenspektrometer verwendet.

Die Erfindung wird nachstehend anhand von Figuren und Beispielen näher erläutert, ohne sie jedoch hierauf zu beschränken.

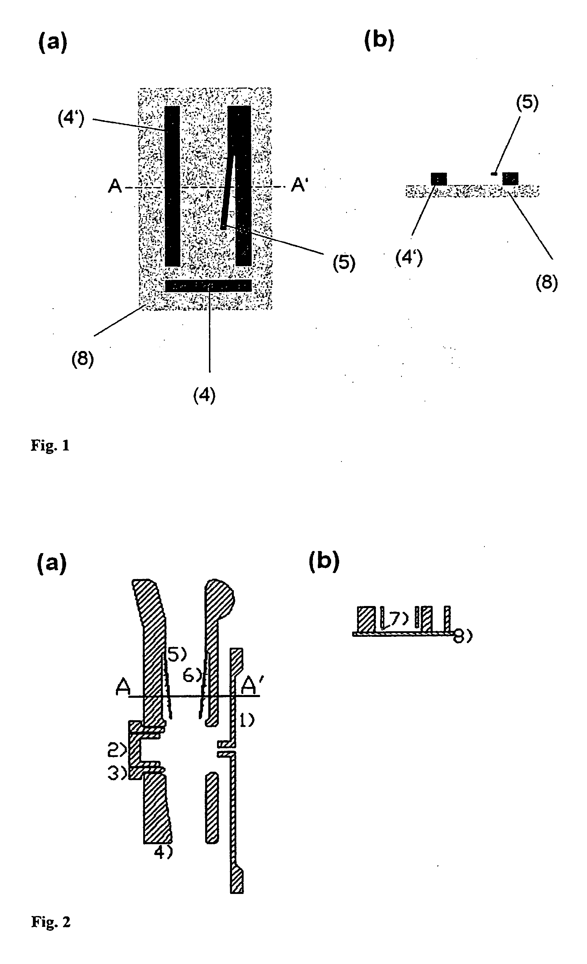

**Figur 1** zeigt eine schematische Darstellung einer einfachen Ausfiihrungsform der erfindungsgemäßen Halterung (a) in der Aufsicht, (b) im Querschnitt durch die Verbindungslinie durch die Punkte A und A' in Fig. 1 (a).

Die gezeigte Ausführungsform verfügt über zwei Anschläge (4, 4') und eine Federstruktur (5), die auf einem nicht leitenden Substrat (8), das hier ausschnittsweise gezeigt ist, aufgebracht sind. Eine Komponente kann von oben in Fig. 1 (a) in den Bereich zwischen dem Anschlag (4') und der Federstruktur (5) eingebracht werden. Die Komponente wird beim Einschieben durch die Federstruktur gegen den Anschlag (4') gedrückt und ihre Lage in dieser Dimension festgelegt. Die Komponente wird so weit in die Halterung geschoben, bis sie gegen den Anschlag (4) reicht. Dieser Anschlag (4) begrenzt die Verschiebung in einer weiteren Dimension. Ein Herausrutschen der Komponente wird durch Federkraft der Federstruktur (5) verhindert. Die Komponente kann jedoch reversibel entfernt werden.

**Figur 2** zeigt schematisch eine bevorzugte Ausführungsform der erfindungsgemäßen Halterung zur selbstjustierenden Montage, Fixierung und elektrischen Kontaktierung einer Mikrokanalplatte in einem Mikrosystem. Fig. 2(a) zeigt die bevorzugte Ausführungsform in der Aufsicht; Fig. 2(b) im Querschnitt durch die Verbindungslinie der Punkte A und A' in Fig. 2(a).

Die erfindungsgemäße Halterung besteht aus leitenden Strukturen (1)-(7), die auf einem nicht leitenden Substrat (8) aufgebracht sind. Der Schirm (1) verhindert, dass hohe elektrische Felder das Messsystem beeinflussen. Der Ionenfänger (2) ist mit einer weiteren Schirmelektrode (3) versehen, die verhindert, dass Ausgleichströme die Elektronerunessung beeinflussen, wenn der Elektronenfänger (2) gegenüber den Federstrukturen (5), (6) auf einer positiven Spannung liegt, um die Elektronen sicher einzufangen. Der mechanische Anschlag (4) für die Mikrokanalplatte ist als keilförmige Führung ausgeführt. Die Federstrukturen (5) und (6) laufen trichterförmig zusammen, um die Mikrokanalplatte zu führen und zwischen Detektorelektrode (2) und Eintrittsöffnung für den Primärstrahl (10) zu fixieren. Die Federstrukturen dienen als Führung und geben einer Mikrokanalplatte gleichermaßen den notwendigen mechanischen Halt. Sie sind aus einem leitfähigen Material (z.B. dotiertes Silizium), so dass sie eine Mikrokanalplatte beiderseits kontaktieren. Die Federstrukturen sind freistehend und nicht mit dem nicht leitenden Substrat verbunden, um sicherzustellen, dass diese beim Einführen einer Mikrokanalplatte nachgeben und gleichermaßen eine ausreichende Kraft auf die Mikrokanalplatte ausüben, um diese zu fixieren. In der gezeigten Ausfiihrungsform sind die Strukturen, welche die Federstrukturen (5, 6), den Anschlag (4), den Schirm (1), den Ionenfänger (2) und die weitere Schirmelektrode (3) bilden, in einem Herstellungsprozess zusammen mit weiteren Strukturen des Mikrosystems (z.B. Mikromassenspektrometer) erzeugt worden. Beispiele für Mikromassenspektrometer und die Methoden zu deren Herstellung, die auch zur Herstellung der erfindungsgemäßem Halterung angewendet werden können, finden sich in den Artikeln "Mass spectra measure by a fully integrated MEMS mass spectrometer" von J.-P. Hauschild, E. Wapelhorst und J. Müller, veröffentlicht im International Journal of Mass Spectrometry 264 (2007) 53-60 (siehe vor allem Abschnitt 3 *Fabrication*) und *"*Complex MEMS: A fully integrated TOF micro mass spectrometer" veröffentlicht in Sensors and Actuators A: Physical, 138 (1) (2007), 22-27 (siehe vor allem Abschnitt 3 *Fabrication*)*.*

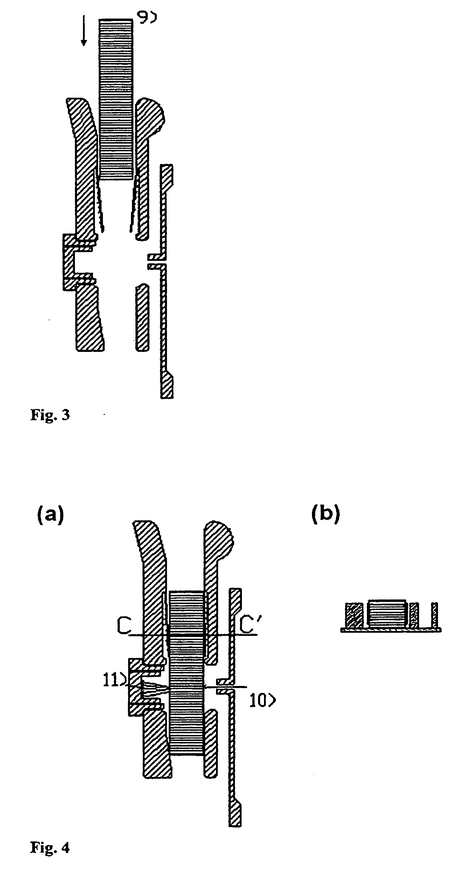

**Figur 3** zeigt schematisch, wie eine Mikrokanalplatte (9) in die erfindungsgemäße Halterung aus Fig. 2 eingeführt wird. Der Pfeil zeigt die Bewegungsrichtung der Mikrokanalplatte (9) beim Einführen an.

**Figur 4** zeigt eine erfindungsgemäße Vorrichtung, umfassend eine Halterung und eine Mikrokanalplatte (a) in der Aufsicht, (b) im Querschnitt durch die Verbindungslinie zwischen den Punkten C und C' in Fig. 4(a). In Figur 4 hat die Mikrokanalplatte, die in Figur 3 in die Halterung eingeschoben wird, ihren Endpunkt erreicht. Durch die Federstrukturen und den Anschlag ist die Mikrokanalplatte selbstjustierend gehaltert. Die elektrisch leitenden Federstrukturen vermitteln zudem einen elektrischen Kontakt.

Im Betrieb tritt der einfallende Primärstrahl (10) (Elektronen, Ionen, Photonen) durch eine Blende im Schirm (1) hindurch und trifft auf die Mikrokanalplatte (9). Die aus der Kanalplatte heraustretenden Elektronen (11) werden vom Elektronenfänger eingefangen.

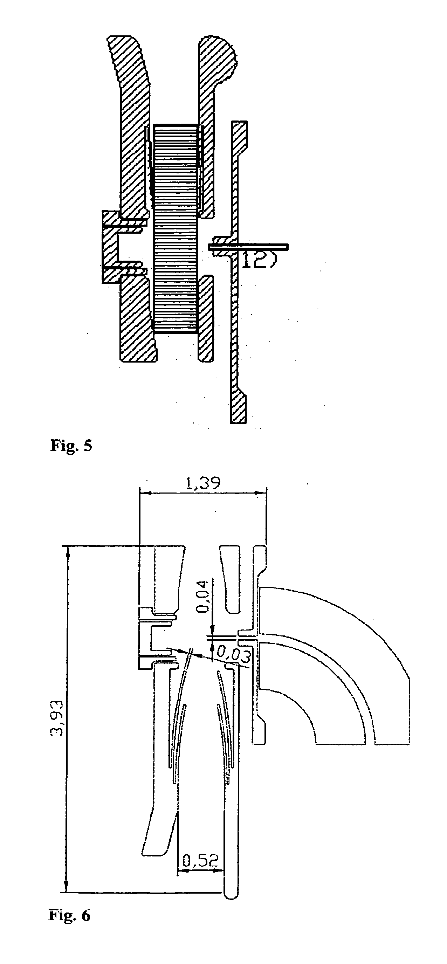

**Figur 5** zeigt schematisch eine alternative Ausfiihrungsform der erfindungsgemäßen Vorrichtung umfassend eine Halterung und eine Mikrokanalplatte, bei der eine optische Faser (12) durch den Schirm geführt wird, so dass die Mikrokanalplatte als optischer Detektor wirkt.

**Figur 6** zeigt eine weitere Ausführungsform der erfindungsgemäßen Halterung, die besonders zur Aufnahme einer Mikrokanalplatte geeignet ist. Die Strukturen, die auf Glas als einem nicht leitendem Substrat aufgebracht sind, bestehend aus dotiertem Silizium. Die Halterung ist auf einem Chip eines Mikromassenspektrometers gemäß dem Artikel in Sensors and Actuators A: Physical, 138 (1) (2007) Seiten 22-27 integriert und wurde zusammen mit den übrigen Strukturen des Massenspektrometers hergestellt. Der Schlüsselprozess zur Herstellung ist die Übertragung der Struktur mittels Phootolithographie und anschließendem trockenchemischen Ätzen der Strukturen (Bosch-Prozess, siehe z.B. "Mikrosystemtechnik für Ingenieure" von W. Menz. J. Mohr und O. Paul, Wiley-VCH, Weinheim 2005). Die Zahlen geben die Maße der Strukturen in mm an. Wie aus der Figur ersichtlich wurden jeweils zwei Federstrukturen an den gegenüberliegenden Seiten der Öffnung der Halterung angebracht. Die Öffnung (die Mikrokanalplatte wird in der der Figur 6 gezeigten Halterung von unten eingeführt) weist einen trichterförmigen Verlauf auf, um die Mikrokanalplatte besser führen zu können und die Einfuhr zu erleichtern.

Im Prinzip lassen sich alle kommerziell erhältlichen Mikrokanalplatten in die erfindungsgemäße Halterung einsetzen; ggf. müssen sie auf die hier verwendbare Größe von 2 x 0,6 mm zugeschnitten werden. Beispielsweise kann die Mikrokanalplatte mit der Bezeichnung G10-2x0.6/ST/6 der Firma Photonics verwendet werden.

## Patentansprüche

1. Verwendung einer Halterung, die mindestens eine leitende Federstruktur (5,6) zum Justieren. Fixieren und Kontaktieren einer Komponente und mindestens einen Anschlag, (4,4') gegen den die Komponente geschoben wird, umfasst, wobei die mindestens eine Federstruktur (5,6) und der mindestens eine Anschlag (4,4') auf einem nicht leitenden Substrat (8) aufgebracht sind, zur Montage, Halterung und elektrischen Kontaktierung von Mikrokanalplatten (9) in einem Mikrosystem, insbesondere in einem Mikromassenspektrometer. Elektronenvervielfacher, Nachtsichtsystem, Photovervielfacher, Teilchenzähler oder Strahlendosimeter.

2. Vorrichtung, mindestens umfassend eine Mikrokanalplatte (9) und eine Halterung zur selbstjustierenden Montage und Halterung der Mikrokanalplatte (9) in einem Mikrosystem, wobei die Halterung mindestens eine leitende Federstruktur (5,6) zum Justieren, Fixieren und Kontaktieren der Mikrokanalplatte (9) und mindestens einen Anschlag, gegen den die Mikrokanalplatte (9) geschoben wird, umfasst, und die mindestens eine Federstruktur (5,6) und der mindestens eine Anschlag (4,4') auf einem nicht leitenden Substrat (8) aufgebracht sind.

3. Vorrichtung nach Anspruch 2, weiterhin umfassend mindestens eine Schirmelektrode (3), um das Mikrosystem vor Einflüssen einer Hochspannung an der Mikrokanalplatte zu schützen.

4. Vorrichtung nach einem der Ansprüche 2 oder 3, weiterhin umfassend einen Elektronenfänger (2)

5. Vorrichtung nach einem der Ansprüche 2 bis 4, **dadurch gekennzeichnet, dass** alle Strukturen durch Photolithographie in der gleichen Maskenebene erzeugt wurden.

6. Vorrichtung nach einem der Ansprüche 2 bis 5, **dadurch gekennzeichnet, dass** die Vorrichtung durch ein nicht leitendes Substrat abgedeckt ist.

7. Verwendung einer Vorrichtung nach einem der Ansprüche 2 bis 6 in einem Mikrosystem, insbesondere in einem Mikromassenspektrometer, Elektronenvervielfacher, Nachtsichtsystem, Photovervielfacher, Teilchenzähler oder Strahlendosimeter.

## Claims

1. use of a fixture which comprises at least one conductive spring structure (5, 6) for aligning, fixing and making contact with a component, and at least one stop (4, 4') against which the component is pushed, the at least one spring structure (5, 6) and the at least one stop (4, 4') being applied on a non-conductive substrate (8), for the mounting, fixture and electrical contact-connection of microchannel plates (9) in a microsystem, in particular in a micro mass spectrometer, electron multiplier, night vision system, photomultiplier, particle counter or radiation dosimeter.

2. Device, as least comprising a microchannel plate (9) and a fixture for the self-aligning mounting and fixture of the microchannel plate (9) in a microsystem, the fixture comprising at least one conductive spring structure (5, 6) for maligning, fixing and making contact with the microchannel plate (9), and at least one stop against which the microchannel plate (9) is pushed, and the at least one spring structure (5, 6) and the at least one stop (4, 4') being applied on a non-conductive substrate (8).

3. Device according to Claim 2, furthermore comprising at least one shielding electrode (3) for protecting the microsystem against influences of a high voltage at the microchannel plate.

4. Device according to either of Claims 2 and 3, furthermore comprising an electron trap (2).

5. Device according to any of Claims 2 to 4, **characterized in that** all the structures were produced by photolithography in the same mask plane.

6. Device according to any of Claims 2 to 5, **characterized in that** the device is covered by a non-conductive substrate.

7. Use of a device according to any of Claims 2 to 6 in a microsystem, in particular in a micro mass spectrometer, electron multiplier, night vision system, photomultiplier, particle counter or radiation dosimeter.

## Revendications

1. Utilisation d'un montage qui comprend au moins une structure de ressort conductrice (5, 6) pour l'alignement, la fixation et la mise en contact d'un composant et au moins une butée (4, 4') contre laquelle le composant est déplacé, dans lequel l'au moins une structure de ressort (5, 6) et l'au moins une butée (4, 4') sont mises en place sur un substrat non conducteur (8) pour l'assemblage, le montage et la mise en contact électrique de plaques à microcanaux (9) dans un microsystème, notamment une microspectromètre de masse, un multiplicateur d'électrons, un système de vision nocturne, un photomultiplicateur, un compteur de particules ou un dosimètre de rayonnement.

2. Dispositif comprenant au moins une plaque à microcanaux (9) et un montage pour l'assemblage et la fixation autoalignés de la plaque à microcanaux (9) dans un microsystème, dans lequel le montage comprend au moins une structure de ressort conductrice (5, 6) pour l'alignement, la fixation et la mise en contact de la plaque à microcanaux (9) et au moins une butée contre laquelle est déplacée la plaque à microcanaux (9), et l'au moins une structure de ressort (5, 6) et l'au moins une butée (4, 4') sont mises en place sur un substrat non conducteur (8).

3. Dispositif salon la revendication 2, comprenant en outre au moins une électrode de blindage (3) destinée à protéger le microsystéme des effets d'une haute tension sur la plaque à microcanaux.

4. Dispositif selon l'une des revendications 2 ou 3, comprenant en outre au moins un capteur d-électrons (2).

5. Dispositif selon l'une des revendications 2 à 4, **caractérisé en ce que** toutes les structures ont été réalisées par photolithographie dans le même plan de masquage.

6. Dispositif selon l'une des revendications 2 à 5, **caractérisé en ce que** le dispositif est recouvert d'un substrat non conducteur.

7. Utilisation d'un dispositif selon l'une des revendications 2 à 6 dans un microsystème, notamment dans un microspectromètre de masse, un multiplicateur d'électrons, un système de vision nocturne, un photomultiplicateur, un compteur de particules ou un dosimètre de rayonnement.
